# EUROPEAN PATENT SPECIFICATION

(11) **EP 3 026 707 B1**
(45) Date of publication and mention of the grant of the patent: **08.01.2020**
(21) Application number: 14194818.2
(22) Date of filing: 25.11.2014
(51) Int. Cl.: H01L 33/08, H01L 33/50, H01L 27/15

(54) **Method for manufacturing a light emitting device comprising at least one color micro-light emitting diode with high luminance**
Verfahren zur Herstellung einer lichtemittierenden Vorrichtung mit mindestens einer farbigen Mikro-Leuchtdiode mit hoher Lichtausbeute
Procédé de fabrication d'un dispositif électroluminescent comprenant au moins une diode micro électroluminescente de couleur ayant une luminance élevée

(43) Date of publication of application: 01.06.2016
(73) Proprietor: Alcatel Lucent, 91620 Nozay (FR); Commissariat à l'Energie Atomique et aux Energies Alternatives, 75015 Paris (FR)
(72) Inventor: Gentner, Jean-Louis, 91460 MARCOUSSIS (FR); Decobert, Jean, 91460 MARCOUSSIS (FR); Poisson, Marie Antoinette, 75008 PARIS (FR)
(74) Representative: Novagraaf Technologies

(56) References cited:
- WO-A1-2012/059837
- US-A1- 2009 033 204
- US-A1- 2010 148 147
- US-A1- 2013 285 086
- US-B1- 7 045 375

## Description

### Field of the Invention

The present invention relates to light emitting devices, and more precisely to manufacture of light emitting devices comprising at least one color micro-light emitting diode.

### Background

In some technical domains, such as displays or projectors, there is a great demand for high resolution and high luminance. Such characteristics may be obtained when the display comprises a large screen or when the projector comprises a big housing, because there is enough place for installing a light emitting device comprising a great number of cells capable of defining a great number of pixels. For instance, each cell may comprise a red light emitting diode (or LED), a green LED and a blue LED capable of producing a lot of colours when they are combined in an appropriate manner.

When the display or projector is very small, as it is the case of micro-displays or pico (or pocket or else handheld) projectors, it is no longer possible to use red, green and blue LEDs in each cell, and therefore high resolution with high luminance cannot be achieved. So, the actual LED technology cannot be used for micro-displays such as head-up displays in avionics, helmet displays, or lens integrated displays for glasses, or for pico-projectors, for instance.

Some attempts have been done with other technologies, such as OLEDs with color filters or converters. But the resulting displays can neither offer a high resolution because of the sizes of their cells nor a high luminance because of limitations introduced by their own technology.

Other attempts have been done with matrices of micro-LEDs. But if blue and green micro-LEDs can be manufactured relatively easily, manufacturing of red micro-LEDs appears to be a very complex task. Indeed light emission beyond 500 nm, while keeping a very good crystallographic quality of the epitaxed structures, is a real challenge because of the low temperature that is required for making them grow and of the luminescence decrease induced by the lattice mismatching. So, only monochromatic micro-displays and micro-projectors can be actually produced with micro-LEDs. US2010/0148147 and WO 2012/059837 disclose forming light emitting devices with structures emitting light at different wavelenths using Metal Organic Vapour Phase Epitaxy based Selective Area Growth. US 7,045,375 discloses bonding an AlGalnP secondary light source to a LED primary source.

### Summary

So an object of this invention is to improve the situation.

A method according to the invention is defined by Claim 1 and a light emitting device according to the invention is defined in Claim 6. Advantageous embodiments may include additional characteristics defined in the dependent claims.

So, each color micro-light emitting diode is capable of generating a light having blue wavelengths by electroluminescence, a light having green wavelengths by electroluminescence, and a light having red wavelengths by conversion of blue wavelengths by photoluminescence.

### Brief Description of the Figures

Some embodiments of a manufacturing method and a light emitting device in accordance with embodiments of the present invention are now described, by way of example only, and with reference to the accompanying drawings, in which:
- Figure 1 schematically illustrates, in a cross section view, an example of light emitting device after implementation of a first sub-step of a manufacturing method according to the invention,
- Figure 2 schematically illustrates, in a cross section view, the example of light emitting device of Figure 1 after implementation of a second sub-step of the manufacturing method according to the invention,
- Figure 3 schematically illustrates, in a cross section view, the example of light emitting device of Figure 1 after implementation of a third sub-step of the manufacturing method according to the invention,
- Figure 4 schematically illustrates, in a cross section view, the example of light emitting device of Figure 1 after implementation of a fourth sub-step of the manufacturing method according to the invention,
- Figure 5 schematically illustrates, in a cross section view, the example of light emitting device of Figure 1 after implementation of a fifth and last sub-step of the manufacturing method according to the invention,
- Figure 6 schematically illustrates, in a top view, a first example of embodiment of a light emitting device according to the invention, and
- Figure 7 schematically illustrates, in a top view, a second example of embodiment of a light emitting device according to the invention.

### Description of Embodiments

Hereafter is notably disclosed a method intended for manufacturing a light emitting device 9 comprising at least one color micro-light emitting diode.

One means here by "color micro-light emitting diode" a micro-light emitting diode capable of producing simultaneously a green light and/or a blue light and/or a red light depending on control signals.

A manufacturing method according to the invention comprises at least two steps.

During a first step at least one green emitting structure 6 is defined on at least one first area of a substrate 1 and at least one blue emitting structure 7 is defined on at least one second area of this substrate 1.

For instance, the substrate 1 may be made of native GaN (Gallium Nitride), SiC (Silicon Carbide), sapphire or silicon.

This first step may be divided in three sub-steps.

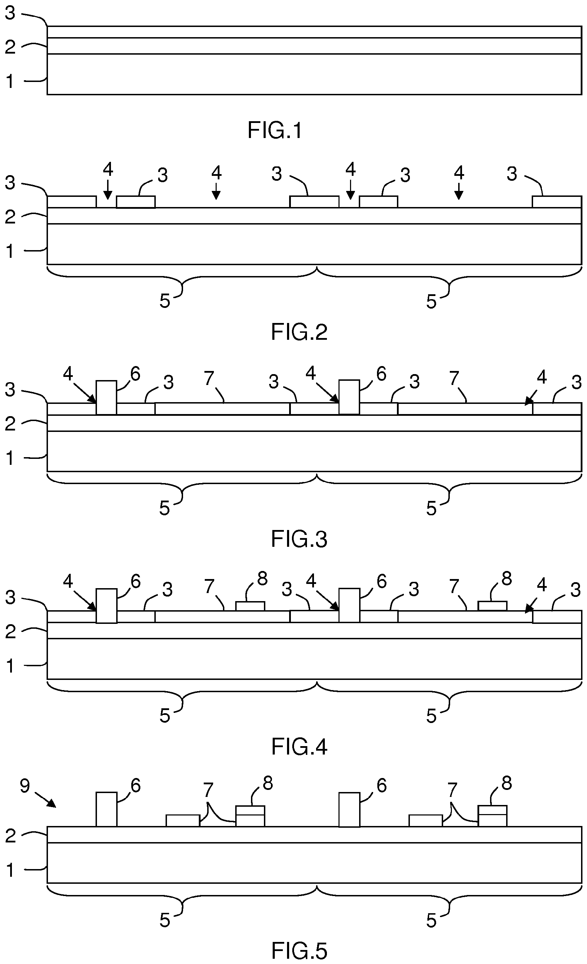

During a first sub-step a buffer layer 2 is grown on the substrate 1 before defining the green emitting structure(s) 6 and the blue emitting structure(s) 7 as illustrated non limitatively in Figure 1. The buffer layer growth is performed by epitaxy.

Also for instance, the buffer layer 2 may be made of GaN (Gallium Nitride).

In order to increase the wavelengths of the green light and blue light, emitted respectively by the green emitting structure(s) 6 and blue emitting structure(s) 7, the buffer layer 2 may include advantageously strained layers.

During a second sub-step of the first method step a dielectric mask 3 may be laid onto the buffer layer 2, also as illustrated non limitatively in Figure 1. The dielectric mask 3 may be made of SiO₂ material.

Then, during a third sub-step of the first method step, openings 4 may be defined by etching in the dielectric mask 3 in locations where the green emitting structure(s) 6 and the blue emitting structure(s) 7 must be defined, as illustrated non limitatively in Figure 2. Then, the green emitting structure(s) 6 and the blue emitting structure(s) 7 are defined in their respective locations defined by the openings 4, as illustrated non limitatively in Figure 3.

Each green emitting structure 6 and each blue emitting structure is defined by Metal Organic Vapour Phase Epitaxy based Selective Area Growth (or "MOVPE based SAG"). Preferably all the green emitting structures 6 and blue emitting structures 7 are defined simultaneously in all the different parts 5 of the substrate 1. Such a growth technique being well-known by those skilled in the art, it will not be described hereafter. The openings 4 are etched in the dielectric mask 3 in order to promote the Selective Area Growth effect during the subsequent growth step. Local modification of growth rate induced by mask pattern can be modeled using a gas phase diffusion solver.

Also for instance, each green emitting structure 6 and each blue emitting structure 7 may be a Single Quantum Well (or SQW) or a Multiple Quantum Wells (or MQW). Moreover, in the case where the buffer layer 2 is made of GaN, each green emitting structure 6 and each blue emitting structure 7 may be made of InGaN/GaN (Indium Gallium Nitride/Gallium Nitride) materials. These materials and arrangements allow generation of light with high luminance. But other materials capable of generating a light having blue wavelengths or a light having green wavelengths by electroluminescence may be used.

In the MOVPE based SAG technique, each blue emitting structure 7 is preferably grown in areas far from the influence of the dielectric mask 3, and each green emitting structure 6 is preferably grown in narrower openings where the growth rate enhancement factor due to the SAG effect is largest.

During a second step of the manufacturing method at least one red emitting structure 8 is bonded on top of at least one sub-part of the blue 7 or green 6 emitting structure, as illustrated non limitatively in Figure 4. Each red emitting structure 8 is arranged for converting a blue or green light, emitted by the associated sub-part of underlying blue 7 or green 6 emitting structure, into a red light by photoluminescence. In fact, the material of the red emitting structure 8 is excited by the blue or green light generated by the underlying blue 7 or green 6 emitting structure, which induces a conversion of the blue or green wavelength into red wavelength by photoluminescence.

At the end of this second step, illustrated non limitatively in Figure 5, each green emitting structure 6 defined on a part 5 of the substrate 1, and each blue emitting structure 7 and each red emitting structure 8 defined on the same part 5 of the substrate 1, define together a color micro-light emitting diode at least partly.

In the following description it is considered, as illustrated in the Figures, that during the second step at least one red emitting structure 8 is bonded on top of at least one sub-part of the blue emitting structure 7. But in a variant of embodiment during the second step at least one red emitting structure 8 could be bonded on top of at least one sub-part of the green emitting structure 6.

For instance, each red emitting structure 8 may be first defined separately in a wafer form and then added (or reported) to the upper face of a blue emitting structure 7 in a predefined sub-part, by means of any bonding technique known by those skilled in the art. This wafer and the underlying blue emitting structure 7 are then structured or patterned (for instance etched) to get their final shape. Then the dielectric mask 3 is removed. But it could eventually be left on at least a part of at least some chosen surfaces for processing purposes. For instance in this case, a red emitting structure 8 may be bond over the total surface of the green 6 and blue 7 emitting structures and then later structured by etching to cover partly only at least one blue emitting structure 7. This gives a clear advantage above other manufacturing methods as it is the only wafer scale technique (i.e. wafer to wafer bonding and collective structuring of emitting structures after bonding).

For instance, each red emitting structure 8 may be a Single Quantum Well (or SQW) or a Multiple Quantum Wells (or MQW). Moreover, in the case where the buffer layer 2 is made of GaN and the blue emitting structures 7 are made of InGaN/GaN, each red emitting structure 8 may be made of AllnGaP/GaAs (Aluminium Indium Gallium Phosphide/Gallium Arsenide) materials. These materials and arrangements allow generation of light with high luminance. But other materials capable of converting blue wavelengths into red wavelength by photoluminescence may be used.

Preferably, the manufacturing method further comprises a third step during which the green emitting structure(s) 6, blue emitting structure(s) 7 and red emitting structure(s) 8 of each substrate part 5 are individually connected to an external driving circuit, for instance via conductive tracks or by flip-chip bonding or else by any other means known by those skilled in the art.

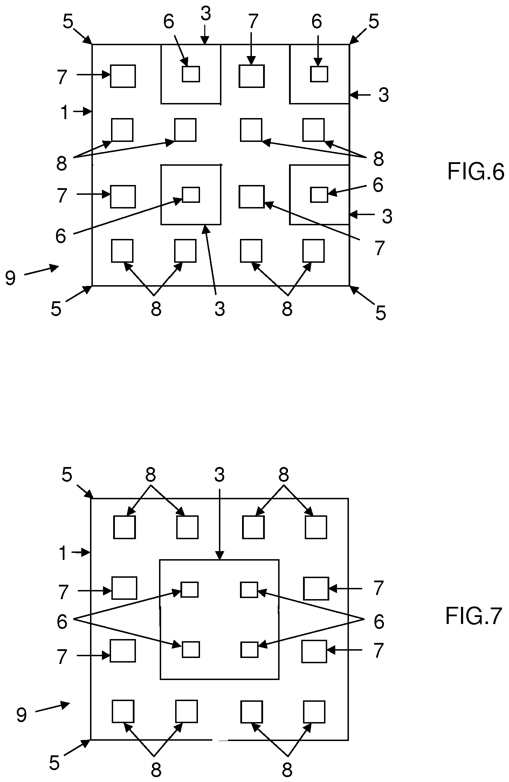

A first example of a light emitting device 9 manufactured by means of the method described above is schematically illustrated in Figure 6. In this non-limiting first example, the substrate 1 comprises four parts 5 defining together a square and respectively associated to four identical color micro-light emitting diodes or cells having the same orientation. Therefore, the light emitting device 9 comprises four cells capable of defining respectively four pixels. But a light emitting device 9 may comprise any number of cells, as soon as this number is greater or equal to one (1).

A second example of a light emitting device 9 manufactured by means of the method described above is schematically illustrated in Figure 7. In this non-limiting second example, the substrate 1 comprises four parts 5 defining together a square and respectively associated to four identical color micro-light emitting diodes or cells having four different orientations. Therefore, the light emitting device 9 comprises four cells capable of defining respectively four pixels.

In the non-limiting first and second examples, each color micro-light emitting diode or cell comprises one green emitting structure 6, one blue emitting structure 7 and two red emitting structures 8. Here, the number of red emitting structures 8 is two times greater than the number of green emitting structures 6 and the number of blue emitting structures 7, in order to compensate for the lower efficiency of the indirect red conversion process. But a color micro-light emitting diode or cell may comprise at least one green emitting structure 6, at least one blue emitting structure 7 and at least one red emitting structure 8. Moreover, the differents cells of a light emitting device 9 may have different arrangements (i.e. different numbers of green emitting structures 6 and/or different numbers of blue emitting structures 7 and/or different numbers of red emitting structures 8).

So, the invention allows manufacturing light emitting devices 9, with at least one color micro-light emitting diode, that may equip numerous equipments, apparatuses, installations or devices, and notably micro-displays (such as head-up displays in avionics, helmet displays, or lens integrated displays for glasses), and pico-projectors, for instance, possibly with high resolution and high luminance.

It should be appreciated by those skilled in the art that any block diagram herein represent conceptual views of illustrative circuitry embodying the principles of the invention.

The description and drawings merely illustrate the principles of the invention. It will thus be appreciated that those skilled in the art will be able to devise various arrangements that, although not explicitly described or shown herein, fall within the scope of the claims. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions.

## Claims

1. Method for manufacturing a light emitting device (9) comprising at least one color micro-light emitting diode, said method comprising a first step in which a buffer layer (2) is grown by epitaxy on a substrate (1), then at least one green emitting structure (6) is defined by Metal Organic Vapour Phase Epitaxy based Selective Area Growth on at least one first area of said buffer layer (2) and at least one blue emitting structure (7) is defined by Metal Organic Vapour Phase Epitaxy based Selective Area Growth on at least one second area of said buffer layer (2), and **characterized in that** said method further comprises
a second step in which at least one red emitting structure (8) is bonded on top of at least one sub-part of said blue or green emitting structure (7), said red emitting structure (8) being arranged for converting a blue or green light emitted by said sub-part of blue (7) or green (6) emitting structure into a red light by photoluminescence, and said green (6), blue (7) and red (8) emitting structures defining said color micro-light emitting diode at least partly.

2. Method according to claim 1, wherein in said first step said buffer layer (2) includes strained layers to increase wavelengths of said green light and blue light emitted respectively by said green emitting structure(s) (6) and said blue emitting structure(s) (7).

3. Method according to claim 2, wherein in said first step a dielectric mask (3) is laid onto said buffer layer (2), and openings (4) are defined by etching in said dielectric mask (3) in locations where said green emitting structure(s) (6) and said blue emitting structure(s) (7) must be defined.

4. Method according to one of claims 2 1 to 3 5, wherein said buffer layer (2) is made of GaN material, said green emitting structure(s) (6) and blue emitting structure(s) (7) are made of InGaN/GaN materials, and each red emitting structure (8) is made of AllnGaP/GaAs materials.

5. Method according to one of claims 1 to 4, wherein it further comprises a third step in which said green emitting structure(s) (6), blue emitting structure(s) (7) and red emitting structure(s) (8) are individually connected to an external driving circuit.

6. Light emitting device (9) comprising a substrate (1), a buffer layer (2) grown by epitaxy on said substrate (1), at least one green emitting structure (6) defined by Metal Organic Vapour Phase Epitaxy based Selective Area Growth on at least one first area of at least one part (5) of said buffer layer (2), at least one blue emitting structure (7) defined by Metal Organic Vapour Phase Epitaxy based Selective Area Growth on at least one second area of said part (5) of said buffer layer (2), and **characterized in that** said light emitting device further comprises
at least one red emitting structure (8) bonded on top of at least one sub-part of at least one blue (7) or green (6) emitting structure defined on said part (5) of said substrate (1), said red emitting structure (8) being arranged for converting a blue or green light emitted by said sub-part of blue (7) or green (6) emitting structure into a red light by photoluminescence, and said green (6), blue (7) and red (8) emitting structures defining a color micro-light emitting diode at least partly and being individually connected to an external driving circuit.

7. Light emitting device according to claim 6, wherein said buffer layer (2) is made of GaN material, and wherein said green emitting structure(s) (6) and blue emitting structure(s) (7) are made of InGaN/GaN materials, and each red emitting structure (8) is made of AllnGaP/GaAs materials.

8. Light emitting device according to one of claims 6 and 7, wherein said substrate (1) comprises at least two parts (5) on which are defined respectively at least two color micro-light emitting diodes.

9. Equipment comprising at least one light emitting device (9) according to one of claims 6 to 8.

## Patentansprüche

1. Verfahren zur Herstellung einer lichtemittierenden Vorrichtung (9), umfassend mindestens eine Farb-Mikro-Leuchtdiode, wobei das Verfahren einen ersten Schritt umfasst, in welchem eine Pufferschicht (2) durch Epitaxie auf ein Substrat (1) aufgewachsen wird, dann wird mindestens eine grünemittierende Struktur (6) durch auf metallorganischer Dampfphasenepitaxie basierendes selektives Flächenwachstum auf mindestens einer ersten Fläche der Pufferschicht (2) definiert und mindestens eine blauemittierende Struktur (7) wird durch auf metallorganischer Dampfphasenepitaxie basierendes selektives Flächenwachstum auf mindestens einer zweiten Fläche der Pufferschicht (2) definiert, und **dadurch gekennzeichnet, dass** das Verfahren ferner umfasst:
einen zweiten Schritt, in welchem mindestens eine rotemittierende Struktur (8) oben auf mindestens einem Subteil der blau- oder grünemittierenden Struktur (7) aufgebondet wird, wobei die rotemittierende Struktur (8) eingerichtet ist zum Umwandeln eines durch den Subteil der blau(7)- oder grün(6)-emittierenden Struktur emittierten blauen oder grünen Lichts durch Photolumineszenz in ein rotes Licht und wobei die grün(6)-, blau(7)- und rot (8) -emittierenden Strukturen die Farb-Mikro-Leuchtdiode zumindest teilweise definieren.

2. Verfahren nach Anspruch 1, wobei die Pufferschicht (2) in dem ersten Schritt gedehnte Schichten aufweist, um die Wellenlängen des jeweils durch die grünemittierende(n) Strukture(n) (6) und die blauemittierende(n) Strukture(n) (7) emittierten grünen Lichts und blauen Lichts zu erhöhen.

3. Verfahren nach Anspruch 2, wobei in dem ersten Schritt eine dielektrische Maske (3) auf die Pufferschicht (2) aufgelegt wird und Öffnungen (4) durch Ätzen in der dielektrischen Maske (3) an Stellen definiert werden, wo die grünemittierende(n) Struktur(en) (6) und die blauemittierende(n) Struktur(en) (7) definiert werden sollen.

4. Verfahren nach einem der Ansprüche 1 bis 3, wobei die Pufferschicht (2) aus GaN-Material hergestellt ist, die grünemittierende(n) Struktur(en) (6) und die blauemittierende(n) Struktur(en) (7) aus InGaN/GaN-Materialien hergestellt sind und jede rotemittierende Struktur (8) aus AlInGaP/GaAs-Materialien hergestellt ist.

5. Verfahren nach einem der Ansprüche 1 bis 4, wobei es ferner einen dritten Schritt umfasst, in welchem die grünemittierende(n) Struktur(en) (6), die blauemittierende(n) Struktur(en) (7) und die rotemittierende(n) Struktur (en) (8) einzeln mit einer externen Treiberschaltung verbunden werden.

6. Lichtemittierende Vorrichtung (9), umfassend ein Substrat (1), eine Pufferschicht (2), durch Epitaxie auf das Substrat (1) aufgewachsen, mindestens eine grünemittierende Struktur (6), durch auf metallorganischer Dampfphasenepitaxie basierendes selektives Flächenwachstum auf mindestens einer ersten Fläche von mindestens einem Teil (5) der Pufferschicht (2) definiert, und mindestens eine blauemittierende Struktur (7), durch auf metallorganischer Dampfphasenepitaxie basierendes selektives Flächenwachstum auf mindestens einer zweiten Fläche des Teils (5) der Pufferschicht (2) definiert,
und **dadurch gekennzeichnet, dass** die lichtemittierende Vorrichtung ferner umfasst:
mindestens eine rotemittierende Struktur (8), die oben auf mindestens einem Subteil von mindestens einer blau(7)- oder grün(6)-emittierenden Struktur, definiert auf dem Teil (5) des Substrats (1), aufgebondet ist, wobei die rotemittierende Struktur (8) eingerichtet ist zum Umwandeln eines durch den Subteil der blau(7)- oder grün(6)-emittierenden Struktur emittierten blauen oder grünen Lichts durch Photolumineszenz in ein rotes Licht und wobei die grün (6)-, blau (7)- und rot (8)-emittierenden Strukturen eine Farb-Mikro-Leuchtdiode zumindest teilweise definieren und einzeln mit einer externen Treiberschaltung verbunden sind.

7. Lichtemittierende Vorrichtung nach Anspruch 6, wobei die Pufferschicht (2) aus GaN-Material hergestellt ist und wobei die grünemittierende(n) Struktur(en) (6) und die blauemittierende(n) Struktur(en) (7) aus InGaN/GaN-Materialien hergestellt sind und jede rotemittierende Struktur (8) aus AlInGaP/GaAs-Materialien hergestellt ist.

8. Lichtemittierende Vorrichtung nach einem der Ansprüche 6 und 7, wobei das Substrat (1) mindestens zwei Teile (5) umfasst, auf welchen jeweils mindestens zwei Farb-Mikro-Leuchtdioden definiert sind.

9. Ausrüstung, umfassend mindestens eine lichtemittierende Vorrichtung (9) nach einem der Ansprüche 6 bis 8.

## Revendications

1. Procédé pour fabriquer un dispositif électroluminescent (9) comprenant au moins une microdiode électroluminescente de couleur, ledit procédé comprenant une première étape au cours de laquelle une couche tampon (2) est développée par épitaxie sur un substrat (1), ensuite au moins une structure émettant dans le vert (6) est définie par une croissance de zone sélective basée sur une épitaxie en phase vapeur organique métallique sur au moins une première zone de ladite couche tampon (2) et au moins une structure émettant dans le bleu (7) est définie par une croissance de zone sélective basée sur une épitaxie en phase vapeur organique métallique sur au moins une seconde zone de ladite couche tampon (2) et **caractérisé en ce que** ledit procédé consiste en outre
une deuxième étape au cours de laquelle au moins une structure émettant dans le rouge (8) est collée au-dessus d'au moins une sous-partie de ladite structure émettant dans le bleu (7) ou dans le vert, ladite structure émettant dans le rouge (8) étant conçue pour convertir une lumière bleue ou verte émise par ladite sous-partie de la structure émettant dans le bleu (7) ou dans le vert (6) en une lumière rouge par photoluminescence, et lesdites structures émettant dans le vert (6), dans le bleu (7) et dans le rouge (8) définissant ladite microdiode électroluminescente de couleur au moins partiellement.

2. Procédé selon la revendication 1, dans lequel, au cours de ladite première étape, ladite couche tampon (2) comprend des couches contraintes pour augmenter des longueurs d'onde de ladite lumière verte et de ladite lumière bleue émises respectivement par ladite ou lesdites structures émettant dans le vert (6) et par ladite ou lesdites structures émettant dans le bleu (7).

3. Procédé selon la revendication 2, dans lequel, au cours de ladite première étape, un masque diélectrique (3) est posé sur ladite couche tampon (2) et des ouvertures (4) sont définies par gravure dans ledit masque diélectrique (3) à des emplacements où ladite ou lesdites structures émettant dans le vert (6) et ladite ou lesdites structures émettant dans le bleu (7) doivent être définies.

4. Procédé selon l'une des revendications 1 à 3, dans lequel ladite couche tampon (2) est composée d'un matériau à base de GaN, ladite ou lesdites structures émettant dans le vert (6) et ladite ou lesdites structures émettant dans le bleu (7) sont composées de matériaux à base de InGaN/GaN et chaque structure émettant dans le rouge (8) est composée de matériaux à base de AllnGaP/GaAs.

5. Procédé selon l'une des revendications 1 à 4, dans lequel il comprend en outre une troisième étape au cours de laquelle ladite ou lesdites structures émettant dans le vert (6), ladite ou lesdites structures émettant dans le bleu (7) et ladite ou lesdites structures émettant dans le rouge (8) sont raccordées individuellement à un circuit d'attaque externe.

6. Dispositif électroluminescent (9) comprenant un substrat (1), une couche tampon (2) développée par épitaxie sur ledit substrat (1), au moins une structure émettant dans le vert (6) définie par une croissance de zone sélective basée sur une épitaxie en phase vapeur organique métallique sur au moins une première zone d'au moins une partie (5) de ladite couche tampon (2), au moins une structure émettant dans le bleu (7) définie par une croissance de zone sélective basée sur une épitaxie en phase vapeur organique métallique sur au moins une seconde zone de ladite partie (5) de ladite couche tampon (2) et **caractérisé en ce que** ledit dispositif électroluminescent comprend en outre au moins une structure émettant dans le rouge (8) collée au-dessus d'au moins une sous-partie d'au moins une structure émettant dans le bleu (7) ou dans le vert (6) définie sur ladite partie (5) dudit substrat (7), ladite structure émettant dans le rouge (8) étant conçue pour convertir une lumière bleue ou verte émise par ladite sous-partie de la structure émettant dans le bleu (7) ou dans le vert (6) en une lumière rouge par photoluminescence, et lesdites structures émettant dans le vert (6), dans le bleu (7) et dans le rouge (8) définissant une microdiode électroluminescente de couleur au moins partiellement et étant raccordées individuellement à un circuit d'attaque externe.

7. Dispositif électroluminescent selon la revendication 6, dans lequel ladite couche tampon (2) est composée d'un matériau à base de GaN et dans lequel ladite ou lesdites structures émettant dans le vert (6) et ladite ou lesdites structures émettant dans le bleu (7) sont composées de matériaux à base de InGaN/GaN et chaque structure émettant dans le rouge (8) est composée de matériaux à base de AllnGaP/GaAs.

8. Dispositif électroluminescent selon l'une des revendications 6 et 7, dans lequel ledit substrat (1) comprend au moins deux parties (5) sur lesquelles sont définies respectivement au moins deux microdiodes électroluminescentes de couleur.

9. Équipement comprenant au moins un dispositif électroluminescent (9) selon l'une des revendications 6 à 8.
